# EUROPEAN PATENT SPECIFICATION

(11) **EP 2 486 413 B1**
(45) Date of publication and mention of the grant of the patent: **31.12.2014**
(21) Application number: 10785509.0
(22) Date of filing: 08.10.2010
(51) Int. Cl.: G01R 21/00, H01F 38/32, G01R 15/14, G01R 15/18

(54) **ELECTROMAGNETIC MEASURING DEVICE FOR MEASURING ELECTRIC CURRENT**
ELEKTROMAGNETISCHE MESSVORRICHTUNG ZUR STROMMESSUNG
DISPOSITIF ÉLECTROMAGNÉTIQUE DE MESURE DE COURANTS ÉLECTRIQUES

(30) Priority: 08.10.2009 IT UD20090177
(43) Date of publication of application: 15.08.2012
(73) Proprietor: ACEGAS-APS SPA, 34121 Trieste (IT); Elcon Elettronica Srl, 34012 Trieste (IT)
(72) Inventor: GENERALI, Luciano, I-34121 Trieste (IT); BOZIC, Marino, I-34100 Trieste (IT); MANIA', Paolo, I-34121 Trieste (IT); PICCOLI, Giovanni, I-34136 Trieste (IT); CARRATU', Massimo, I-34100 Trieste (IT)
(74) Representative: Petraz, Gilberto Luigi
(86) International application number: PCT/IB2010/002554
(87) International publication number: WO 2011/042805

(56) References cited:
- EP-A1- 1 059 536
- WO-A1-02/31953
- WO-A1-2006/048020
- US-A- 3 842 344
- US-A- 4 717 994
- US-A- 5 068 776
- US-A1- 2004 217 755
- US-A1- 2007 139 152
- US-A1- 2007 159 284
- US-A1- 2009 219 007

## Description

### FIELD OF THE INVENTION

The present invention concerns an electromagnetic measuring device for measuring electric quantities, in particular electric current.

To be more exact, the present invention concerns an electromagnetic current measuring device that allows to detect current values on medium and low tension networks and to transmit the data relating to the detection directly to a central system for the necessary acquisitions and processing. In particular, the present invention can be used to survey the intensity and quality of electric energy delivered by a distribution system, it has no external feed sources or wire connection to the measuring instruments, it has a very long operating life and is simple to assemble, and can be installed on low and medium tension lines without interrupting the service.

### BACKGROUND OF THE INVENTION

It is known that, in order to measure electric tensions or currents that exceed the field of measurement allowed for the relative measuring instruments, such as voltmeters or ammeters, current or tension measuring transformers are used.

In particular, current measuring transformers (TA) are used to measure primary line currents much higher than those that can be tolerated by an ammeter connected to its secondary; the insertion of the current transformer is carried out with the primary coil connected in series to the network.

On the contrary, tension measuring transformers (TV) are used to measure tensions at the primary which are much higher than those that can be supported by a voltmeter connected to its secondary; it is also known that the insertion of a tension transformer is carried out with the primary coil connected between the conductors whose tension is to be measured.

One disadvantage of known measuring transformers is that their use is limited only to detecting or measuring tension and/or current values of the electric network, but without allowing to analyze the development thereof over time.

To obtain further information it is necessary to use supplementary apparatuses which not only entail additional costs but also imply somewhat complex installation operations and therefore high management and maintenance costs.

Furthermore, known instruments need an external feed source and require that the distribution service is interrupted when they are installed on low and medium tension lines.

Documents WO2006/048020 A1 and EP1059536 A1 disclose a device corresponding to the preamble of claim 1. Documents US2004/217755 A1 and US2009/219007 A1 constitute background art.

One purpose of the present invention is to achieve an electromagnetic measuring device for electric current that allows to analyze the developments of the tension and/or currents measured avoiding having to install complex apparatuses.

Another purpose of the present invention is to achieve an electromagnetic measuring device for electric current in which the measuring instruments are able to function in every operating condition, identifying and/or signaling possible breakdowns or malfunctions of the electric network on which they are installed.

Another purpose is to achieve an electromagnetic measuring device for electric current which is self-fed, does not need external feed sources and does not need the distribution service to be interrupted in order to be installed.

The Applicant has devised, tested and embodied the present invention to overcome the shortcomings of the state of the art and to obtain these and other purposes and advantages.

### SUMMARY OF THE INVENTION

The present invention is set forth and characterized in the independent claim, while the dependent claims describe other characteristics of the invention or variants to the main inventive idea.

In accordance with the above purposes, an electromagnetic measuring device connectable to a conductor, which functions as a primary, of an electric network, for example a distribution network, comprises:
- connection means to the conductor, comprising a ferromagnetic core, substantially annular in shape, which delimits internally a through aperture in which the conductor is inserted transverse to a plane on which the ferromagnetic core lies, said ferromagnetic core having at least a portion that is selectively configurable in an open position, in which it allows the insertion of the conductor in the through aperture, and a closed position in which it closes the magnetic circuit;
- a secondary coil, coaxially coupled with a coupling portion of said ferromagnetic core, to measure an electric current proportional to the electric current circulating in the conductor;
- at least a supplementary coil, coupled with said coupling portion coaxially with respect to said secondary coil, subjected to a tension proportional to the network current;
- means to measure the electric current, connected to said secondary coil and able to supply an electric signal correlated to the intensity of electric current circulating in said conductor;
- electronic processing and control means, connected both to said secondary coil in order to acquire over time data relating to electric currents of the electric network deriving from the electric signal received from the measuring means, and also to said supplementary coil so as to receive from said supplementary coil a suitable electric feed necessary for functioning, deriving from the electric current that is measured;
- transceiver means associated with said electronic processing and control means and able to transmit said data to a data collection and concentration unit, which transceiver means are fed electrically by said supplementary coil.

According to a variant, the transmission means are of the wireless type, for example infrared, Bluetooth® or other.

In some forms of embodiment, the electromagnetic measuring device comprises means to rectify the current present on the supplementary coil, to feed the processing and control means.

With the present invention it is possible to acquire over time data relating to electric currents of the line to which the electromagnetic measuring device is applied, and also cable downtimes, harmonics present and possible discharges or anomalies to earth or neutral (precursors of breakdowns) and to communicate them, advantageously in wireless mode, to a concentrator and thence to a remote operator.

In some forms of embodiment, the electromagnetic measuring device comprises electronic protection means disposed between the supplementary coil and the electronic processing and control means and suitable to protect at least the processing and control means from overvoltages present on the supplementary coil.

In variants of these embodiments, the electronic protection means comprise a stabilizer device.

In other variants of these embodiments, the electronic protection means comprise an overvoltage suppressor.

In further forms of embodiment, the electromagnetic measuring device comprises electronic means to limit the tension, disposed between the secondary coil and the processing and control means.

According to some forms of embodiment, the electromagnetic measuring device comprises a capacitive divider by means of which it can be configured for insertion as a wattmeter in the electric network.

Another variant of the invention provides that the electromagnetic measuring device comprises at least a temperature sensor, disposed in proximity with the electromagnetic measuring device or remote from it.

According to another variant, the data collection and concentration unit is equipped with an identification unit, for example a transponder, which processes the signals sent from associated transponder units that can be transported by operators.

According to another variant, the data collection and concentration unit is provided with a geo-positioning unit.

According to a variant, the data collection and concentration unit comprises solar energy electric feed means.

According to another variant, the data collection and concentration unit is also equipped with an actuation unit able to activate and/or switch off a user load associated with the network.

The present invention also concerns a local network for the measurement and transmission of data relating to the measurement of electric current of conductors of feed lines of an electric network comprising a plurality of electromagnetic measuring devices as set forth above, at least a data collection and concentration unit that functions as a data transmission and reception node, said data collection and concentration unit being provided with means to receive signals arriving from said electromagnetic measuring devices and means to transmit said data toward a central processing and control unit or server, associated with said electric network.

### BRIEF DESCRIPTION OF THE DRAWINGS

These and other characteristics of the present invention will become apparent from the following description of a preferential form of embodiment, given as a non-restrictive example with reference to the attached drawings wherein:
- fig. 1 is a schematic view of the electromagnetic measuring device according to the present invention;
- fig. 2 is a schematic view of one form of embodiment of the electromagnetic measuring device according to the present invention;
- fig. 3 is a schematic view of part of the electromagnetic measuring device in fig. 2;
- fig. 4 is a schematic block view of the electromagnetic measuring device in fig. 1, the data collection and concentration unit and the electronic processing and control means;
- fig. 5 is a schematic block view of a variant of fig. 4;
- fig. 6 shows an installation of the electromagnetic measuring device according to the present invention on electric energy feed lines;
- fig.7 is an enlarged detail of fig. 6.

To facilitate comprehension, the same reference numbers have been used, where possible, to identify common elements in the drawings that are substantially identical. It is understood that elements and characteristics of one form of embodiment can conveniently be incorporated into other forms of embodiment without further clarifications.

### DETAILED DESCRIPTION OF A PREFERENTIAL FORM OF EMBODIMENT

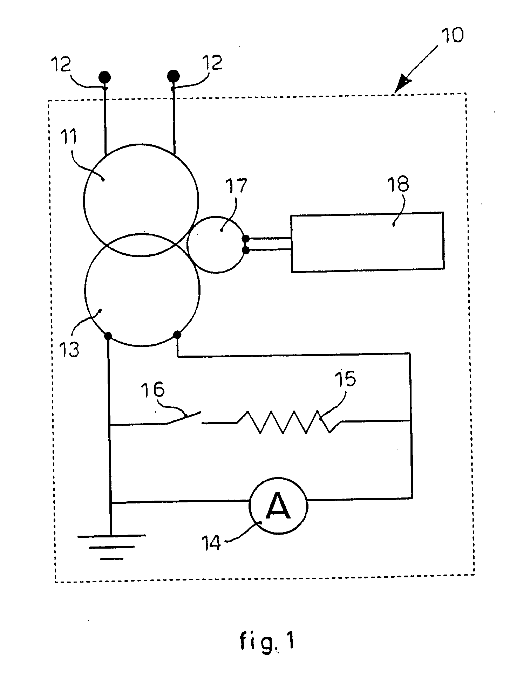

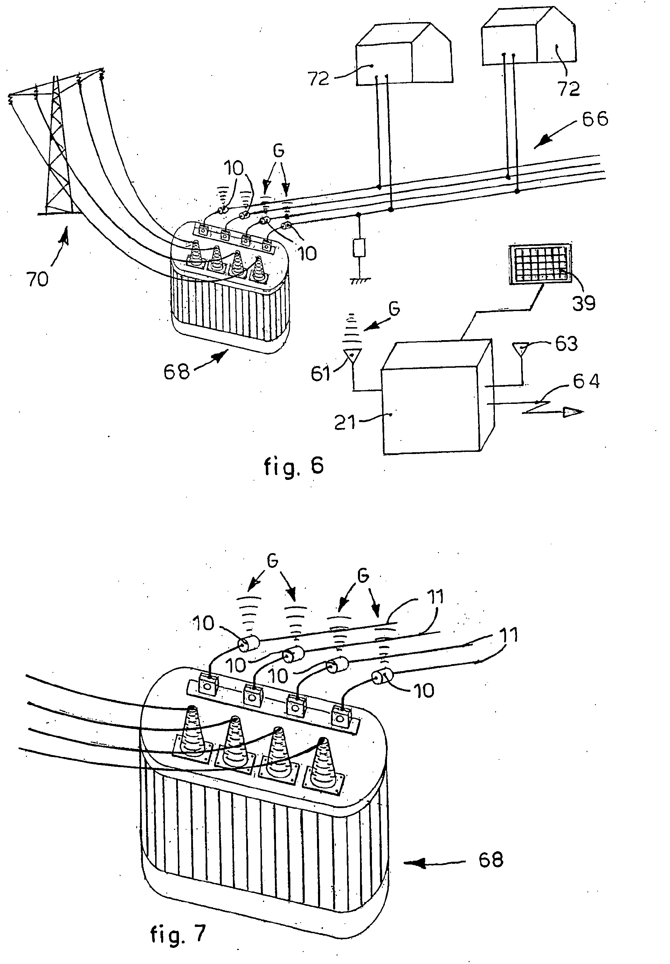

With reference to the attached drawings, an electromagnetic measuring device 10 to measure electric quantities, in particular electric current, according to the present invention is associable to a conductor 11, in this case an electric current feed cable, which functions as a primary (figs. 1, 2 and 3) of a low or medium tension feed line of an electric distribution network 66 toward user devices, for example domestic users 72 (fig. 6). In particular, figs. 6 and 7 show the electromagnetic measuring device 10 installed on conductors 11 connected to a transformation substation 68, in turn connected to an electric current distribution pole 70.

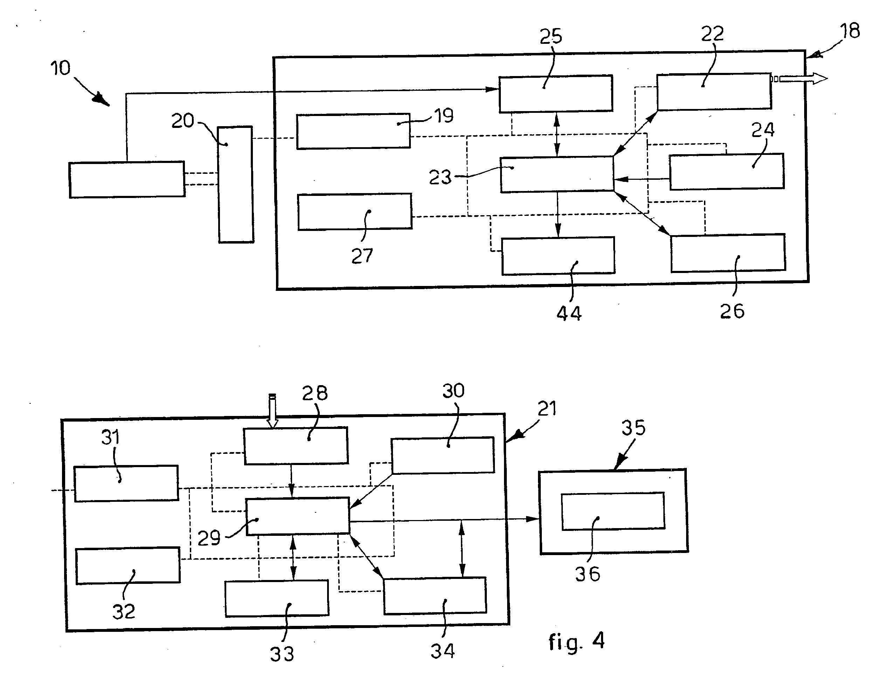

The electromagnetic measuring device 10 comprises a secondary coil 13 and a supplementary coil 17, connection means 12 for connection to the conductor 11 of the electric network of which the current is to be measured, an electronic processing and control unit 18 and a data collection and concentration unit or concentrator 21 (fig. 4).

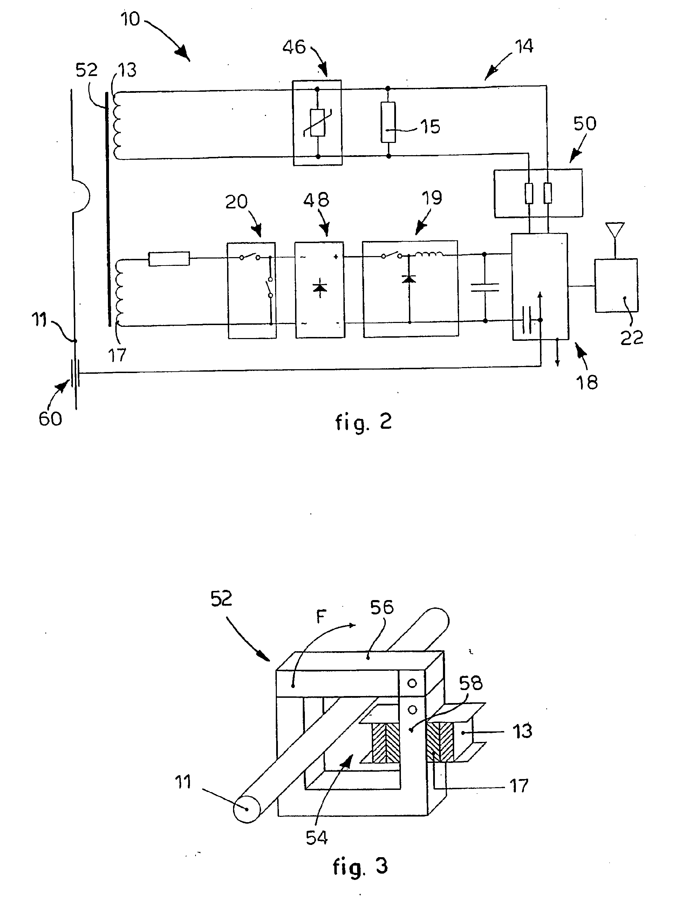

The connection means 12 comprise a ferromagnetic core 52 (figs. 2 and 3), conformed annularly, that is, with a closed coil conformation, for example a closed toroid or a clamp or gripper or any other mean able to effect a fixed or semi-fixed installation surrounding a conductor, as can be seen for example in figs. 2, 3, 6 and 7. In some forms of embodiment, the ferromagnetic core 52 delimits internally a through aperture 54, in which the conductor 11 is inserted so that it is substantially coaxial to the ferromagnetic core 52 that surrounds it. In some forms of embodiment, advantageous to surround the conductor 11 during assembly, the ferromagnetic core 52 has a portion 56 selectively configurable, for example movable or removable as indicated by the arrow F in fig. 3, between an open position in which it allows the conductor 11 to be inserted inside the through aperture 54 transversely to a plane on which the ferromagnetic core lies, and a closed portion in which it closes the magnetic circuit.

In particular, the secondary coil 13 and the supplementary coil 17 are wound coaxially around a common portion 58 of the ferromagnetic core 52, the secondary coil 13 being disposed in a more external position than the supplementary coil 17 with respect to the portion 58, and positioned above the supplementary coil 17.

For the installation of the electromagnetic measuring device 10, the portion 56 of the ferromagnetic core 52 is opened and the electromagnetic measuring device 10 is mounted astride the conductor 11 which functions as a primary, achieving a measurement transformer.

It is simple to adapt the various conductors or cables whose electric current is to be measured, since the ferromagnetic core 52 of the electromagnetic measuring device 10 can be opened and therefore is able to "surround" any conductor or bar just like a clamp or gripper instrument.

A measuring instrument 14 is connected to the secondary coil 13, in this case an ammeter, although it is understood that, in a different type of installation, the measuring instrument can be a voltmeter. The possibility is also provided of excluding the measuring instrument 14 with a resistive load 15 by means of a suitable switch 16, to allow for example to remove the measuring instrument 14.

The supplementary coil 17 is comprised in the electromagnetic measuring device 10 according to a predetermined transformation ratio so as to obtain a current proportional to the network load value, and also suitable to transmit data relating to the measurement to the electronic processing and control unit 18. The electronic processing and control unit 18, suitably fed by a stabilizer, of a known type and not shown in fig. 1, allows to acquire and process the signals detected in a form suitable to be transmitted to the data collection and concentration unit 21.

Furthermore, the electric feed for the functioning of the measuring instrument 14 and the electronic processing and control unit 18 arrives, thanks to the supplementary coil 17, from the electric current that is measured; as will be explained in more detail hereafter.

Typically, the secondary coil 13, which allows the measurements, works loaded almost in a condition of short circuit, supplying a current that possesses a certain ratio with the current circulating to the conductor 11 functioning as a primary.

Depending on the current that can be delivered to the secondary coil 13 and on other parameters, the transformer determined by the coupling of the electromagnetic measuring device 10 and the conductor 11 has an electric power defined performance, which for example is on average 5 VA.

The secondary nominal current at the lower end of the scale in a transformer of the type in question is usually about 1 or 5 amperes, therefore in a 100/5 transformer, when a current of 100 amperes flows through the only primary spiral, on the secondary, generally loaded by an internal resistance instrument equal to 60 milliohm, 5 amperes will flow.

The tension measured, if any, at the heads of the measuring instrument 14 associated with the transformer as described above is generally equal to a couple of hundred millivolts, useful for making measurements but not useful as a source of feed.

With the present invention, the further supplementary coil 17 is added to the traditional transformer configuration: it does not deliver current on low impedance like the secondary measuring coil 13 or that of normal feed transformers, but delivers a tension on high impedance. The tension is extremely variable depending on the primary current and passes from a value of zero with primary current equal to zero to a very high value in the case of maximum current. The tension ratio from zero to full load is 0/100.

Given that below 10% of the nominal current at the lower end of the scale the current transformer does not give appreciable accuracy, with the addition of the supplementary coil 17 it is possible to deliver a useful tension to the electronic part starting from 10% of the nominal current of the transformer. The value of the tension is typically 5 volts.

Under this value the electronic part of the processing and control unit 18 and the measuring instrument 14 is not operative.

This means that when, there are 10 amperes flowing in the conductor 11 that makes up the primary of the transformer (for example a 100/5), the tension at the heads of the supplementary coil 17 will be 5 volts. With maximum nominal current, however, this tension goes up to 50 volts. With intermediate current values it will be proportional to the transformation ratio.

In the event of a short circuit, in the line measured, the current can assume a peak value of 15,000 amperes for 1 second and therefore the tension at the heads of the supplementary coil 17 will be able to reach values equal to 150 times the maximum nominal output tension, that is, 50x150 = 7500 volts.

A tension that is so widely variable, and so dangerously high in the event of line breakdowns, is not useful as a source of feed for the electronic part represented by the processing and control unit 18 and the measuring instrument 14.

To this end, according to some embodiments of the present invention, a stabilizer device 19 is used which functions as a switching system in order to regulate and stabilize the tension at the required value of 5 volts, and a transient suppressor 20, also called limitation system, or in technical jargon tension "trimmer", to trim the tension to values near the maximum 60 volts in the event of higher input tensions. Between the stabilizer device 19 and the transient suppressor 20 in some forms of embodiment a rectifier element 48 is provided, which rectifies the tension present on the supplementary coil 17 in order to feed the processing and control unit 18.

The saturation of the ferromagnetic core 52, provided during the design step of the transformer at 120% of the nominal current, constitutes a further protection since it flattens the increase in secondary tension and prevents it from reaching extreme values (7500 volts) that can be reached with the non-saturated core.

Moreover, an element 50 is provided to protect the tension at input to the electronic component of the processing and control unit 18.

Another protection against excessive and destructive overvoltage is given by a tension limiter 46 that functions as an active element located parallel to the measurement resistance able to short circuit tensions with a value greater than expected present at the heads of the secondary in the event of short-circuits in the line.

By using such safety stratagems, it is possible to use the device 10 for auto-feeding the electronic part dedicated to measuring the electric current and to transmitting it remote and represents a characteristic feature of the present invention.

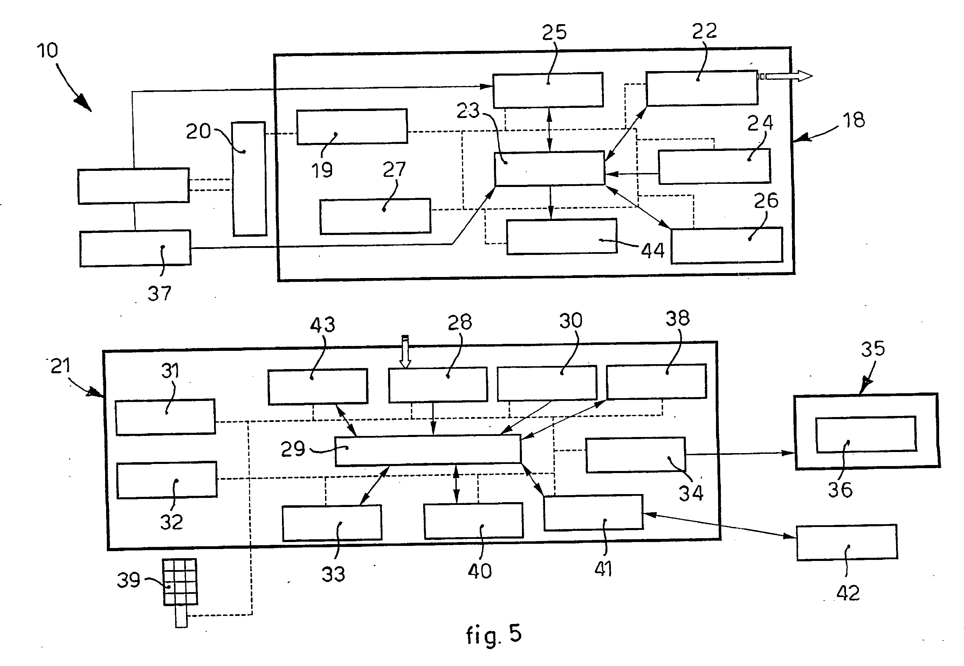

In particular, with reference to figs. 4 and 5, the data collection and concentration unit 21 and the processing and control unit 18 are shown schematically, with a line of dashes indicating the feed connections of the components, and continuous lines indicating the interactions between the various elements.

The electronic processing and control unit 18, in some forms of embodiment, comprises a microcontroller, or microprocessor 23, a transceiver 22, a real time clock 24, a digitizer unit 25, for example an analog-digital convertor, a memory 26, a communication interface 44, a micro-accumulator 27 and the stabilizer device 19.

As mentioned above, the auto-feed of the electromagnetic measuring device 10, and in particular of the processing and control unit 18 and the measuring instrument 14, provides that, of the two secondary coils 13, 17 present, the secondary coil 13 is suitably charged (80-100% of nominal current) by a resistance. The signal taken at the heads of the resistance will represent the signal in current present at the conductor 11 which functions as a primary and will be sent to the entrance of the A/D convertor of the micro-processor of the processing and control unit 18. The tension present on the supplementary coil 17, on the contrary, will be rectified, with appropriate stratagems, by means of a rectifier element 48 and used to feed the electronic part, as will be explained in more detail hereafter.

Advantageously, the load of the secondary coil 13 of the transformer, to prevent non-linearity and errors that would take it outside the class of measurement declared, is preferably 25% greater than the nominal one of the measurement transformer and approximates a short-circuit condition (60-200 milliohm).

It is preferable to operate with a greater load or equal to 80%, and therefore the transformer finds itself operating within the limits of its performance.

The possible introduction of distortions due to the rectification of the tension of the supplementary coil 17 is irrelevant: for example, having an absorbed current of 50mA maximum compared with 2.5 average working amperes of the secondary coil 13. If this were to create an unacceptable distortion, rectification can be carried out with a PFC device (Power Factor Control) upstream.

The energy availability has shown itself to be more than sufficient to be able to keep the microcontroller or micro-processor 23 of the processing and control unit 18 always active. The micro-processor 23, in some forms of embodiment, will be involved in calculating a fast Fourier transform (FFT) at determinate times, and in measuring microinterruption times, and therefore cannot be deactivated.

Therefore, in a totally innovative way, the present invention uses the supplementary coil 17, as well as the secondary measuring coil 13, for harvesting auto-feed power from the electronic measuring and data transmission part.

The synergic combination, in the functioning modes described, of the supplementary coil 17 and the secondary coil 13, allows to recover energy from the conductor 11 measured, in order to feed the electronic part on board and to carry out a series of measurements and transmit them remotely, without needing any feed from a network or from batteries.

Another feature of the present invention is given by the capacity of the electromagnetic measuring device 10 to achieve a local wireless network and to connect to the data collection and concentration unit 21 which functions as a central node, advantageously supported in electric feed by means of photovoltaic means, such as a photovoltaic collector 39 from which the data collected, further processed and suitably compacted, will be sent to the central data processing and management unit, or network server (arrow 64) of the company distributing the energy.

The energy harvested thanks to the supplementary coil 17 is used to feed the electronic processing and transmission/reception part and possibly to keep in a buffer the micro-accumulator 27, to keep active the communication with the data collection and concentration unit 21, when energy is removed from the conductor 11 on which the electromagnetic measuring device 10 is attached.

The transceiver 22, for example of the wireless type, uses known technology such as ZigBee, Bluetooth® or suchlike to transfer the data. The data are transmitted by the transceiver 22 to the data collection and concentration unit 21 by means of frequency signals that will be at a pre-established frequency (for example 2.4 GHz, 915MHz, 868 MHz, 433 MHz, 315 MHz): these values are fixed according to the type of transceiver and receiver used.

The real time clock 24, for example an RTC component easily found on the market, allows to identify the instant of time in which a given event occurs and allows to apply temporal identifiers on the signal transmitted.

The data read by the electromagnetic measuring device 10 are detected with a sampling interval that is sufficiently small and correlated to the variations in tensions and/or currents to be measured, so as to obtain an accurate evaluation of the development of tension and/or current. The transmission of the data occurs by variance of the signal or, alternatively, at predetermined time instants; in the case of stable time values, the data are sent a predetermined number of times, interrupting the transmission until there is a subsequent variation in the signal read. It is understood that the signal can be transmitted substantially periodically.

The digitizer unit 25 allows to convert the data read from analog to digital, so as to allow them to be transferred through the transceiver 22. The digitizer unit 25, with the aid of the micro-controller 23, carries out a harmonic analysis (FFT) of the signal read, determining the amplitude of a number of harmonics of the tension and/or current signal able to obtain a desired approximation, for example by sampling the amplitudes of the third, fifth and seventh harmonic.

The stabilizer device 19 is suitable to stabilize to a substantially constant value the tension available at the heads of the supplementary coil 17, in order to obtain a desired and stable continuous feed tension for the electronic instruments, avoiding peaks and sudden and transitory reductions of the feed tension; again in order to protect the electronic processing and control unit 18, parallel to the heads of the supplementary coil 17 the transient suppressor 20 is disposed, which has a trigger tension slightly higher than the maximum feed tension of the electronic means 18; the energy deriving from the peaks of tension and/or current due to short circuits on the measuring line is dissipated by the transient suppressor 20.

The purpose of the memory 26 is to memorize temporarily, according to its capacity, the data that will be transferred later to the processing and control unit; this allows, for example in the event of a breakdown, to recover a part of the prior data so as to allow a subsequent analysis of the causes that provoked it. The communication interface 44 allows for example the operator to identify a given electromagnetic measuring device 10 or breakdown conditions or suchlike.

The micro-accumulator 27, in the event of a breakdown or temporary interruption of the network, allows to feed the electronic processing and control unit 18 to provide for it to function, and allow the transceiver 22 to communicate that there is no network energy or a possible breakdown.

The energy consumption of the electronic processing and control unit 18 of the electromagnetic measuring device 10 is completely negligible with respect to the power present on the secondary 13.

The data collection and concentration unit 21 comprises a second micro-controller 29, a receiver 28 provided with a reception antenna 61, a second real time clock 30, a feed system 31 supported, in the event of an interruption of the electric feed, by a buffer battery 32, a buffer memory 33 and a communication unit 34 provided with a transmission antenna 63.

The data collection and concentration unit 21 is able to receive signals from several electromagnetic measuring devices 10 that are disposed for example in a transformation substation, on a distribution pole or directly on cables of the distribution network.

The data collection and concentration unit 21, disposed remote from the electromagnetic measuring device 10, receives with the receiver 28 the signal sent by the transceiver 22.

The second micro-controller 29 provides to exchange information between the various elements of the data collection and concentration unit 21 and to process the data received.

The second real time clock 30 allows to determine the instant in which a given event takes place.

The feed unit 31 in general is connected to the electric network present for example in the substation in which the data collection and concentration unit 21 is located.

A buffer battery 32 is also provided, which begins to function if there is a breakdown in the feed unit 31 or a momentary interruption in the electric feed network.

The buffer memory 33 allows to store data for a certain period of time; this allows to examine, in the event of a breakdown, the data prior to the breakdown.

The communication unit 34 allows to transfer data with a known technology, for example via internet or conveyed wave to the base station 35.

The base station 35 is provided with a processor 36 which allows to monitor the level of load of the various lines of the network, to detect possible anomalies or breakdowns registered and to manage such problems.

Fig. 3 presents a variant of the electromagnetic measuring device 10 according to the present invention.

The electromagnetic measuring device 10 is provided with a temperature sensor 37 which allows to control the functioning temperature of the electromagnetic device 10 or the environment where it is installed, for example a transformation substation, and transmits the temperature value of the environment where it is located; the signal is sent in a known manner to the electronic processing and control unit 18 to be subsequently transferred to the data collection and concentration unit 21 and therefore available for the operator in the base station 35.

The actuation unit 38 is able to activate and/or switch off a user load associated with the network when the latter exceeds a pre-established threshold or is harmful for the electric network, for example due to problems of overheating, or other functions, for example remote control. Alternatively, the actuation unit 38 can be commanded from the base station 35, whose intervention instructions are sent to appropriate actuation means (not shown).

The data collection and concentration unit 21 in this case is fed by the photovoltaic means 39 in order to render the unit independent of the feed network.

It is also provided to use a geo-positioning unit 40, for example using GPS technology, which allows to localize geographically the substation or pole or suchlike on which the electromagnetic measuring devices 10 are located.

The data collection and concentration unit 21 is also used as an identification unit 41 of transponders 42 carried by an operator and fed, for example, by batteries. The data collection and concentration unit 21 is equipped with an identification unit 41 able to interact with the operator's transponder 42. The identification unit 41 allows to start a series of activities that guarantee the operator's safety when his presence is detected.

Another detection unit 43 will allow to detect unauthorized persons inside the substation and will allow to send a signal to the base station 35.

Figs. 6 and 7 show how a plurality of electromagnetic electric current measuring devices 10 can be installed on conductors 11 exiting from a transformation substation 68, in turn connected upstream to a distribution pole 70 of a distribution network 66 to users 72, to define a local network for measuring and transmitting electric current data.

It can be seen how each electromagnetic measuring device 10 can be coupled astride the conductors 11, in particular in the detail in fig. 7, without interrupting the distribution service.

Furthermore, in Fig. 6 it can be appreciated how each electromagnetic measuring device 10 is able to communicate the values measured in wireless mode, reference G, to the data collection and concentration unit 21, equipped with the reception 61 and transmission 63 antennas, advantageously fed by means of the photovoltaic means 39, which in turn communicates the values, arrow 64, to the server of the Company that manages the distribution of electric energy.

It is clear that modifications and/or additions of parts may be made to the electromagnetic measuring device 10 as described heretofore, without departing from the field and scope of the present invention.

For example, in some forms of embodiment, the electromagnetic measuring device 10 comprises a capacitive divider 60 (fig. 2), by means of which it is configurable for insertion as a wattmeter in said electric network.

Moreover, in some forms of embodiment, it is possible to insert into the electric measuring networks both a device to acquire current and also tension, in this way obtaining a complete analysis of the load acting on the lines; in the same way it is possible to use several devices according to the present invention, each disposed on every line of the network so as to verify the balancing of the loads on the lines.

## Claims

1. Electromagnetic measuring device connectable to a conductor (11), which functions as a primary, of an electric network (66), comprising:
- connection means (12) to the conductor (11) comprising a ferromagnetic core (52), substantially annular in shape, which delimits internally a through passage (54) in which the conductor (11) is inserted transverse to a plane on which the ferromagnetic core (52) lies;
- a secondary coil (13) coaxially coupled with a coupling portion (58) of said ferromagnetic core (52), so as to measure an electric current proportional to the electric current circulating in the conductor (11);
- at least a supplementary coil (17) subject to a tension proportional to the network current; and
- means for measuring (14) the electric current, connected to said secondary coil(13) and able to provide an electric signal correlated to the intensity of electric current circulating in said conductor (11);
**characterised in that**:
- said ferromagnetic core (52) has at least a portion selectively configurable in an open position, in which it allows the conductor (11) to be inserted into the through aperture (54), and a closed position in which it closes the magnetic circuit;
- said supplementary coil (17) is coupled with said coupling portion (58) coaxially with respect to said secondary coil (13);
- the device further comprises electronic processing and control means (18), connected both to said secondary coil (13) to acquire over time data relating to electric currents of the electric network, deriving from the electric signal received from the measuring means (14), and also to said supplementary coil (17) to receive from said supplementary coil (17) a suitable electric feed necessary for functioning, deriving from the electric current that is measured; and
- the device further comprises transceiver means (22) associated with said electronic processing and control means (18) and able to transmit said data to a data collection and concentration unit (21), which transceiver means (22) are fed electric by said supplementary coil (17).

2. Electromagnetic measuring device as in claim 1, **characterized in that** said transmission/reception means (22) are of the wireless type.

3. Electromagnetic measuring device as in claim 1 or 2, **characterized in that** it comprises rectifier means (48) to rectify the tension present on the supplementary coil (17), to feed said processing and control means (18).

4. Electromagnetic measuring device as in claim 1, 2 or 3, **characterized in that** it comprises electronic protection means (19, 20) disposed between said supplementary coil (17) and said electronic processing and control means (18) and suitable to protect at least said processing and control means (18) from overvoltages present on the supplementary coil (17).

5. Electromagnetic measuring device as in claim 4, **characterized in that** said electronic protection means comprise a stabilizer device (19).

6. Electromagnetic measuring device as in claim 4 or 5, **characterized in that** said electronic protection means comprise a transient suppressor (20).

7. Electromagnetic measuring device as in any claim hereinbefore, **characterized in that** it comprises electronic tension limitation means (50) disposed between the secondary coil (13) and the processing and control means (18).

8. Electromagnetic measuring device as in any claim hereinbefore, **characterized in that** it comprises a capacitive divider (60) by means of which it is configurable for insertion as a wattmeter in said electricity network (66).

9. Electromagnetic measuring device as in any claim hereinbefore, **characterized in that** it comprises at least a temperature sensor (37), disposed in proximity with the electromagnetic device or remote from it.

10. Electromagnetic measuring device as in any claim hereinbefore, **characterized in that** the data collection and concentration unit (21) comprises geo-positioning means (40).

11. Electromagnetic measuring device as in any claim hereinbefore, **characterized in that** the data collection and concentration unit (21) comprises solar energy electric feed means (39).

12. Electromagnetic measuring device as in any claim hereinbefore, **characterized in that** said the data collection and concentration unit (21) comprises an actuation unit (38).

13. Electromagnetic measuring device as in any claim hereinbefore, **characterized in that** the data collection and concentration unit (21) comprises a unit (41) to identify transponders (42) portable by operators.

14. Local network for measuring and transmitting data relating to the measurement of electric current of conductors (11) of feed lines of an electric network (66), comprising a plurality of electromagnetic measuring devices (10) as in any claim hereinbefore, at least a data collection and concentration unit (21) which functions as a transmission/reception node of the data, being provided with reception means (61) for signals arriving from said electromagnetic measuring devices (10) and transmission means (63) to transmit said data to a central data processing and management unit or network server (64), associated with said electric network (66).

## Patentansprüche

1. Elektromagnetische Messvorrichtung, die mit einem Leiter (11) verbindbar ist, welcher als primärer eines elektrischen Netzwerks (66) fungiert, umfassend:
- Verbindungsmittel (12) zum Leiter (11), umfassend einen ferromagnetischen Kern (52) mit im Wesentlichen ringförmiger Gestalt, der innen einen Durchlass (54) begrenzt, in welchem der Leiter (11) quer zu einer Ebene eingeführt ist, in der der ferromagnetische Kern (52) liegt;
- eine Sekundärwicklung (1 3), die koaxial mit einem Kopplungsabschnitt (58) des ferromagnetischen Kerns (52) gekoppelt ist, um einen elektrischen Strom proportional zum Netzwerkstrom zu messen;
- mindestens eine zusätzliche Wicklung (1 7), die unter eine Spannung proportional zu dem im Leiter (11) zirkulierenden Strom steht; und
- Mittel (14) zum Messen des elektrischen Stroms, verbunden mit der Sekundärwicklung (1 3) und geeignet, ein mit der Stärke des im Leiter (11) zirkulierenden elektrischen Stroms korreliertes elektrisches Signal zu liefern;
**dadurch gekennzeichnet, dass**:
- der ferromagnetische Kern (52) wenigstens einen Abschnitt aufweist, der selektiv in einer offenen Position, in der er es ermöglicht, dass der Leiter (11) in den Durchlass (54) eingeführt wird, und einer geschlossenen Position konfigurierbar ist, in der er den magnetischen Kreis schließt;
- die zusätzliche Wicklung (1 7) mit dem Kopplungsabschnitt (58) koaxial in Bezug auf die Sekundärwicklung (13) gekoppelt ist;
- die Vorrichtung weiter elektronische Verarbeitungs- und Steuermittel (18) umfasst, die mit der Sekundärwicklung (1 3) verbunden sind, um im Laufe der Zeit sich auf elektrische Ströme des elektrischen Netzwerks beziehende Daten zu gewinnen, die aus dem vom Messmittel (14) empfangenen elektrischen Signal hergeleitet wurden, und die auch mit der zusätzlichen Wicklung (1 7) verbunden sind, um von der zusätzlichen Wicklung (1 7) eine geeignete, für das Funktioneren erforderliche elektrische Einspeisung zu erhalten, die von dem elektrischen Strom hergeleitet wurde, der gemessen wird; und
- die Vorrichtung weiter Transceivermittel (22) umfasst, die den elektronischen Verarbeitungs- und Steuermitteln (18) zugeordnet sind und geeignet sind, die Daten zu einer Datensammel- und -konzentrationseinheit (21) zu übertragen, welche Transceivermittel (22) von der zusätzlichen Wicklung (17) elektrisch gespeist werden.

2. Elektromagnetische Messvorrichtung nach Anspruch 1, **dadurch gekennzeichnet, dass** die Sende-/Empfangsmittel (22) vom drahtlosen Typ sind.

3. Elektromagnetische Messvorrichtung nach Anspruch 1 oder 2, **dadurch gekennzeichnet, dass** sie Gleichrichtermittel (48) umfasst, um die an der zusätzlichen Wicklung (1 7) anliegende Spannung für das Speisen der Verarbeitungs- und Steuermittel (18) gleichzurichten.

4. Elektromagnetische Messvorrichtung nach Anspruch 1, 2 oder 3, **dadurch gekennzeichnet, dass** sie elektronische Schutzmittel (19, 20) umfasst, die zwischen der zusätzlichen Wicklung (1 7) und den elektronischen Verarbeitungs- und Steuermitteln (1 8) angeordnet sind und geeignet sind, wenigstens die Verarbeitungs- und Steuermittel (1 8) gegen an der zusätzlichen Wicklung (1 7) anliegende Überspannungen zu schützen.

5. Elektromagnetische Messvorrichtung nach Anspruch 4, **dadurch gekennzeichnet, dass** die elektronischen Schutzmittel eine Stabilisierungseinrichtung (19) umfassen.

6. Elektromagnetische Messvorrichtung nach Anspruch 4 oder 5, **dadurch gekennzeichnet, dass** die elektronischen Schutzmittel eine Transientenunterdrückungseinrichtung (20) umfassen.

7. Elektromagnetische Messvorrichtung nach einem beliebigen vorhergehenden Anspruch, **dadurch gekennzeichnet, dass** sie elektronische Spannungsbegrenzungsmittel (50) umfasst, die zwischen der Sekundärwicklung (13) und den Verarbeitungs- und Steuermitteln (1 8) angeordnet sind.

8. Elektromagnetische Messvorrichtung nach einem beliebigen vorhergehenden Anspruch, **dadurch gekennzeichnet, dass** sie einen kapazitiven Teiler (60) umfasst, mittels dessen sie für den Einsatz als Wattmeter im elektrischen Netzwerk (66) konfigurierbar ist.

9. Elektromagnetische Messvorrichtung nach einem beliebigen vorhergehenden Anspruch, **dadurch gekennzeichnet, dass** sie wenigstens einen Temperatursensor (37) umfasst, der in der Nähe der elektromagnetischen Vorrichtung oder entfernt von ihr angeordnet ist.

10. Elektromagnetische Messvorrichtung nach einem beliebigen vorhergehenden Anspruch, **dadurch gekennzeichnet, dass** die Datensammel- und -konzentrationseinheit (21) Geopositionsbestimmungsmittel (40) umfasst.

11. Elektromagnetische Messvorrichtung nach einem beliebigen vorhergehenden Anspruch, **dadurch gekennzeichnet, dass** die Datensammel- und -konzentrationseinheit (21) Solarenergie-Einspeisungsmittel (39) umfasst.

12. Elektromagnetische Messvorrichtung nach einem beliebigen vorhergenden Anspruch, **dadurch gekennzeichnet, dass** die Datensammel- und -konzentrationseinheit (21) eine Betätigungseinheit (38) umfasst.

13. Elektromagnetische Messvorrichtung nach einem beliebigen vorhergehenden Anspruch, **dadurch gekennzeichnet, dass** die Datensammel- und -konzentrationseinheit (21) eine Einheit (41) zur Identifikation von Transpondern (42) umfasst, die von Bedienungspersonen getragen werden.

14. Lokales Netzwerk zum Messen und Übertragen von Daten mit Bezug auf die Messung von elektrischem Strom von Leitern (11) von Zuleitungen eines elektrischen Netzwerks (66), umfassend eine Anzahl von elektromagnetischen Messvorrichtungen (10) gemäß einem beliebigen vorhergenden Anspruch, wenigstens eine Datensammel-und -konzentrationseinheit (21), die als Sende-/Empfangsknoten der Daten fungiert, versehen mit Empfangsmitteln (61) für Signale, die von den elektromagnetischen Messvorrichtungen (10) ankommen, und mit Sendemitteln (63) für das Senden der Daten zu einer zentralen Datenverarbeitungs- und -managementeinheit oder einem Netzwerkserver (64), der dem elektrischen Netzwerk (66) zugeordnet ist.

## Revendications

1. Dispositif de mesure électromagnétique pouvant être connecté à un conducteur (11), qui fonctionne comme un primaire, d'un réseau électrique (66), comportant :
- des moyens de connexion (12) au conducteur (11) comportant un noyau ferromagnétique (52), de forme sensiblement annulaire, qui délimite intérieurement un passage traversant (54) dans lequel le conducteur (11) est inséré transversalement à un plan sur lequel se situe le noyau ferromagnétique (52),
- une bobine secondaire (13) coaxialement couplée à une portion de couplage (58) dudit noyau ferromagnétique (52), de manière à mesurer un courant électrique proportionnel au courant électrique circulant dans le conducteur (11),
- au moins une bobine supplémentaire (17) soumise à une tension proportionnelle au courant de réseau, et
- des moyens (14) pour mesurer le courant électrique, connectés à ladite bobine secondaire (13) et pouvant délivrer un signal électrique corrélé à l'intensité du courant électrique circulant dans le conducteur (11),
**caractérisé en ce que** :
- ledit noyau ferromagnétique (52) a au moins une portion pouvant être configurée sélectivement dans une position ouverte, dans laquelle elle permet une insertion du conducteur (11) dans l'ouverture traversante (54), et une position fermée dans laquelle elle ferme le circuit magnétique,
- ladite bobine supplémentaire (17) est couplée à ladite portion de couplage (58) coaxialement par rapport à ladite bobine secondaire (13),
- le dispositif comporte en outre des moyens de traitement et de commande électroniques (18), connectés à la fois à ladite bobine secondaire (13) pour acquérir au fil du temps des données concernant des courants électriques du réseau électrique, dérivant du signal électrique reçu des moyens de mesure (14), et également à ladite bobine supplémentaire (17) pour recevoir de ladite bobine supplémentaire (17) une alimentation électrique adaptée nécessaire pour fonctionner, dérivant du courant électrique qui est mesuré, et
- le dispositif comporte en outre des moyens d'émission-réception (22) associés auxdits moyens de traitement et de commande électroniques (18) et pouvant transmettre lesdites données à une unité de collecte et de concentration de données (21), lesquels moyens d'émission-réception (22) sont alimentés électriquement par ladite bobine supplémentaire (17).

2. Dispositif de mesure électromagnétique selon la revendication 1, **caractérisé en ce que** lesdits moyens d'émission-réception (22) sont du type sans fil.

3. Dispositif de mesure électromagnétique selon la revendication 1 ou 2, **caractérisé en ce qu'**il comporte des moyens redresseurs (48) pour redresser la tension présente sur la bobine supplémentaire (17), pour alimenter lesdits moyens de traitement et de commande (18).

4. Dispositif de mesure électromagnétique selon la revendication 1, 2 ou 3, **caractérisé en ce qu'**il comporte des moyens de protection électroniques (19, 20) disposés entre ladite bobine supplémentaire (17) et lesdits moyens de traitement et de commande électroniques (18) et adaptés pour protéger au moins lesdits moyens de traitement et de commande (18) contre des surtensions présentes sur la bobine supplémentaire (17).

5. Dispositif de mesure électromagnétique selon la revendication 4, **caractérisé en ce que** lesdits moyens de protection électroniques comportent un dispositif stabilisateur (19).

6. Dispositif de mesure électromagnétique selon la revendication 4 ou 5, **caractérisé en ce que** lesdits moyens de protection électroniques comportent un parasurtenseur (20).

7. Dispositif de mesure électromagnétique selon l'une quelconque des revendications ci-dessus, **caractérisé en ce qu'**il comporte des moyens de limitation de tension électroniques (50) disposés entre la bobine secondaire (13) et les moyens de traitement et de commande (18).

8. Dispositif de mesure électromagnétique selon l'une quelconque des revendications ci-dessus, **caractérisé en ce qu'**il comporte un diviseur capacitif (60) au moyen duquel il peut être configuré en vue d'une insertion en tant que wattmètre dans ledit réseau électrique (66).

9. Dispositif de mesure électromagnétique selon l'une quelconque des revendications ci-dessus, **caractérisé en ce qu'**il comporte au moins un capteur de température (37), disposé à proximité du dispositif électromagnétique ou à distance de celui-ci.

10. Dispositif de mesure électromagnétique selon l'une quelconque des revendications ci-dessus, **caractérisé en ce que** l'unité de collecte et de concentration de données (21) comporte des moyens de géolocalisation (40).

11. Dispositif de mesure électromagnétique selon l'une quelconque des revendications ci-dessus, **caractérisé en ce que** l'unité de collecte et de concentration de données (21) comporte des moyens d'alimentation électrique à énergie solaire (39).

12. Dispositif de mesure électromagnétique selon l'une quelconque des revendications ci-dessus, **caractérisé en ce que** ladite unité de collecte et de concentration de données (21) comporte une unité d'actionnement (38).

13. Dispositif de mesure électromagnétique selon l'une quelconque des revendications ci-dessus, **caractérisé en ce que** l'unité de concentration et de collecte de données (21) comporte une unité (41) pour identifier des transpondeurs (42) pouvant être transportés par des opérateurs.

14. Réseau local pour mesurer et transmettre des données concernant la mesure d'un courant électrique de conducteurs (11) de lignes d'alimentation d'un réseau électrique (66), comportant une pluralité de dispositifs de mesure électromagnétiques (10) selon l'une quelconque des revendications ci-dessus, au moins une unité de collecte et de concentration de données (21) qui fonctionne comme un noeud d'émission/réception des données, munie de moyens de réception (61) pour des signaux provenant desdits dispositifs de mesure électromagnétiques (10) et de moyens de transmission (63) pour transmettre lesdites données à une unité centrale de traitement et de gestion de données ou un serveur de réseau (64), associée audit réseau électrique (66).
